# EUROPEAN PATENT APPLICATION

(11) **EP 2 747 142 A1**
(43) Date of publication of application: **25.06.2014**
(21) Application number: 12198303.5
(22) Date of filing: 20.12.2012
(51) Int. Cl.: H01L 29/739, H01L 29/06, H01L 21/331, H01L 29/08, H01L 29/40

(54) **Insulated gate bipolar transistor and method of manufacturing the same**

(71) Applicant: ABB Technology AG, 8050 Zürich (CH)
(72) Inventor: Corvasce, Chiara, 8962 Bergdietikon (CH); Rahimo, Munaf, 5619 Uezwil (CH); Kopta, Arnost, 8049 Zürich (CH)
(74) Representative: ABB Patent Attorneys

(57) **Abstract**

An insulated gate bipolar transistor (1) having on a wafer (10), which has an emitter electrode (2) on an emitter side (21) and a collector electrode (22) on a collector side (23), an active cell area (12), a termination area (14), which surrounds the active cell area (12), and a channel stopper area (16), which is arranged around the termination area (14) at the edge of the wafer is provided.

In the active cell area (12) a plurality of cells (13) are arranged, each comprising an n type first emitter layer (3), a p type first base layer (4), an n type first enhancement layer (5), an (n-) type drift layer (6), a p type collector layer (7), wherein the first enhancement layer (5) separates the first base layer (4) from the drift layer (6). A plurality of gate electrodes (24) is arranged on the emitter side (21).

In the termination area (14) at least one termination layer (8) is arranged, at which the electric field during operation of the insulated gate bipolar transistor (1) in blocking mode is reduced.

In the channel stopper area (16) a p type second base layer (45) and an n type second enhancement layer (55), which separates the second base layer (45) from the drift layer (6), is arranged.

## Description

### Technical Field

The invention relates to the field of power electronics and more particularly to a insulated gate bipolar transistor according to the preamble of claim 1 and to a method for manufacturing such an insulated gate bipolar transistor according to the preamble of claim 10.

### Background Art

From the prior art document "Carrier stored Trench-gate bipolar Transistor (CSTBT) - A novel power device for high voltage application" by Takahashi et al., IEEE 1996, 349-352 an insulated gate bipolar transistor is known which has an emitter electrode on an emitter side and a collector electrode on a collector side opposite to the emitter side. The device comprises an active cell area, which is surrounded by a termination area and a channel stopper area, which is arranged around the termination area at the edge of the wafer.

In the active cell area a plurality of cells are arranged, each comprising layers in the following order between the emitter side and collector side: an n doped first emitter layer, a p doped first base layer, an n doped first enhancement layer, which separates the first base layer from the drift layer, an (n-) doped drift layer and a p doped collector layer. The emitter electrode is electrically connected to the plurality of first emitter layers and first base layers. A plurality of gate electrodes, trench or planar gate type, is arranged on the emitter side, each of which is separated from any of the layers in the wafer by a first insulating layer and from the emitter electrode by a second insulating layer. The collector electrode is electrically connected to the collector layer. In the termination area termination layers are arranged, at which the electric field during operation of the insulated gate bipolar transistor in blocking mode is reduced.

Such termination layers are described in "Progress in MOS-controlled bipolar devices and edge termination technologies" by E. Narayanan et al., Microelectronics Journal 35 (2004), 235 - 248. Guard rings in form of p doped layers may be arranged on the emitter side surrounding around the active cell area. They are either floating, i.e. not directly electrically connected to the emitter electrode or covered with a semiconducting passivation layer. Metal field plates may also be arranged on top of each guard ring. Such a p doped layer may also be formed as a spiral with some windings around the active cell area.

Alternatively, such metal field plates may also be arranged on top of the wafer in the termination area without a p doped guard ring type below in the wafer.

Around the termination layers, a channel stopper area is arranged, in which the electric field is completely stopped, so that it cannot extend to the lateral edges of the wafer. Such a channel stopper layer is a highly doped n type layer such that during blocking operation, it cannot be depleted more than over a submicron distance, therefore preventing any farer electrical field propagation

All of the technics require special masks for the creation of the various emitter sided layers, e.g. the p base layer and n enhancement layer are made through one mask, the termination layer through another mask and the channel stopper layer through even another mask.

### Disclosure of Invention

It is an object of the invention to provide a carrier stored bipolar semiconductor device, which is easier to manufacture than the known prior art devices.

This object is achieved by a device according to claim 1 and by method for manufacturing such a device according to claim 14.

The inventive insulated gate bipolar transistor has on a wafer, which has an emitter electrode on an emitter side and a collector electrode on a collector side opposite to the emitter side. An active cell area extends from the emitter side to the collector side in a central part of the wafer. A termination area surrounds the active cell area, and a channel stopper area is arranged around the termination area at the edge of the wafer.

In the active cell area a plurality of cells are arranged, each comprising layers in the following order between the emitter side and collector side: a first emitter layer of a first conductivity type, a first base layer of a second conductivity type, which is different from the first conductivity type, a first enhancement layer of the first conductivity type, a drift layer of the first conductivity type, a collector layer of the second conductivity type, wherein the first enhancement layer separates the first base layer from the drift layer. The emitter electrode is electrically connected to the plurality of first emitter layers and first base layers, whereas the collector electrode is electrically connected to the collector layer.

A plurality of gate electrodes are arranged on the emitter side, each of which is separated from any of the layers in the wafer by a first insulating layer and from the emitter electrode by a second insulating layer.

In the termination area at least one termination layer is arranged, at which the electric field during operation of the insulated gate bipolar transistor in blocking mode is reduced. Such a termination layer may exemplarily be at least one layer of the second conductivity type, e.g. guard rings, a spirally wound layer or a VLD layer, or a metal field plate.

In that in the channel stopper area a second base layer of the second conductivity type and a second enhancement layer of the first conductivity type, which separates the second base layer from the drift layer, is arranged.

Exemplarily, the second base layer has the same doping profile as the first base layer and the second enhancement layer has the same doping profile as the first enhancement layer.

Such a semiconductor device can be manufactured by a manufacturing process in which the first base layer in the central part can be created simultaneously with the second base layer in the channel stopper area and the same for the first and second enhancement layers. This reduces the necessity of delicate masking steps, while still keeping possibilities of individual adaption of the layer widths in the central and channel stopper area.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on an inventive semiconductor device with planar gate electrodes and guard rings as termination layer;
- FIG 2: shows a cross sectional view on an inventive semiconductor device with no second emitter layer in the channel stopper area;
- FIG 3: shows a cross sectional view on an inventive semiconductor device with a wide second base layer;
- FIG 4: shows a cross sectional view on an inventive semiconductor device with a VLD layer as termination layer;
- FIG 5: shows a cross sectional view on an inventive semiconductor device with trench gate electrodes and guard rings as termination layer;
- FIG 6: shows a cross sectional view on an inventive semiconductor device with a electrically conductive plate and a semiconducting layer, which is electrically connected to the second base layer, the termination layers and the emitter electrode;
- FIG 7: shows a cross sectional view on an inventive semiconductor device with a semiconducting layer electrically connected to the second base layer, the termination layers and the emitter electrode.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

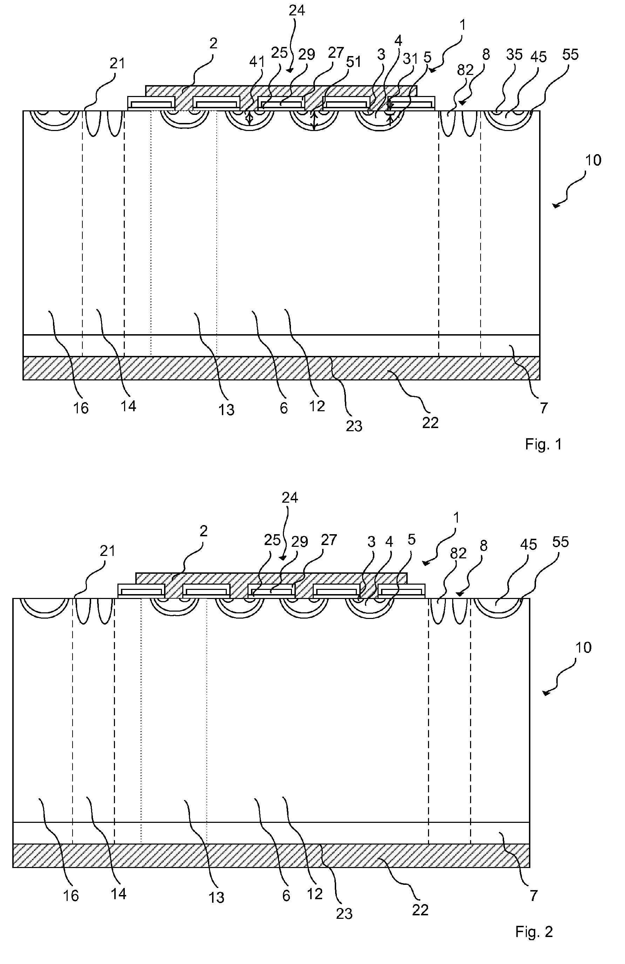

In a first embodiment shown in Fig. 1, an inventive insulated gate bipolar transistor 1 comprises a wafer 10 having an emitter electrode 2 on an emitter side 21 and a collector electrode 22 on a collector side 23 opposite to the emitter side 21. In the wafer 10, an active cell area 12 extends from the emitter side 21 to the collector side 23 in a central part of the wafer, a termination area 14 surrounds the active cell area 12, and a channel stopper area 16 is arranged around the termination area 14 at the edge of the wafer. Both, the termination area 14 and the channel stopper area 16, therefore, also extend from the emitter to the collector side 21, 23. That means that the term "central" refers only to the planes parallel to the emitter side; perpendicular to that direction, the areas extend through the whole wafer, i.e. from the emitter to the collector side 21, 23. The edge is arranged perpendicular to the emitter side on a border of the wafer.

In the active cell area 12 a plurality of cells 13 are arranged, each comprising layers in the following order between the emitter side 21 and collector side 23: an n doped first emitter layer 3, optionally, a highly doped p contact layer, a p doped first base layer 4, an n doped first enhancement layer 5, an (n-) doped drift layer 6, a p doped collector layer 7. The first enhancement layer 5, thus, separates the first base layer 4 from the drift layer 6. It has a higher doping concentration than the drift layer 6.

The emitter electrode 2 is electrically connected to the plurality of first emitter layers 3 and first base layers 4. On the collector side 23, the collector electrode 22 is electrically connected to the collector layer 7.

The choice of the doping concentration and thicknesses of the drift layer 6 depends on the blocking capability requirements. The low-doped drift layer 6 is the main region for supporting the blocking voltage on the main PN junction emitter side. The drift layer 6 is a constantly low doped layer. Exemplary thickness of a drift layer for a 600 V device is 30 to 70 µm, 80 to 120 µm for a 1200 V device and 150 to 190 µm for a 1700 V device. The doping concentration for a lower voltage device is exemplarily higher than for a higher voltage device, e.g. around 1.5 * 10¹⁴ cm⁻³ for a 600 V device down to 5 * 10¹³ cm⁻³ for a 1700 V device. However, the concrete values for a device may vary depending on its application.

As well-known to the experts, such a device having the drift layer arranged directly neighboured to the collector layer is a non-punch through power semiconductor device. Thus, the (n-) doped drift layer 6 is in contact to the collector layer 7 without having a highly doped layer of the first conductivity type (called buffer layer) in between. The electric field in blocking condition for a non-punch-through device is triangular and stops within the drift layer 6. The space charge region does not reach the collector layer 7.

Alternatively. a buffer layer 65, which has a higher doping concentration than the drift layer 6, may be arranged on the drift layer 6 towards the collector side 23. A device comprising such a buffer layer (which buffer layer has higher doping concentration than the constantly low-doped drift layer, either constantly high doped, gradually rising doping concentration or with steadily, continuously increasing doping concentration towards the collector side)) is called a punch-through device. At higher blocking voltages the electric field at the border between the drift and buffer layer will not have reached zero. Along a short distance in the buffer layer it is then steeply decreased to zero due to the high doping concentration.

A plurality of gate electrodes 24, 24' is arranged on the emitter side 21, each of which comprises an electrically conductive gate layer 29, 29', which is separated from any of the layers in the wafer 10 by a first insulating layer 25, 25' and from the emitter electrode 2 by a second insulating layer 27, 27'.

The gate electrodes 24, 24' may be formed as planar gate electrodes 24 comprising the gate layer 29 and a first and second insulating layer 25, 27 as shown in FIG 1. The first electrically insulating layer 25 is arranged on top of wafer on the emitter side 21, electrically insulating the gate layer 29 from any n or p doped layer in the wafer (i.e. from the first emitter layer, the first base layer, the first enhancement layer and the drift layer). The second electrically insulating layer 27 covers the electrically conductive layer 29 and, thus, insulates the gate layer 29 from the emitter electrode 2. Therefore, in between the first and second electrically insulating layers 25, 27, which are exemplarily made of silicon dioxide, the electrically conductive gate layer 29 is embedded, exemplarily it is completely embedded. The electrically conductive gate layer 29 is typically made of a heavily doped polysilicon or a metal like aluminum.

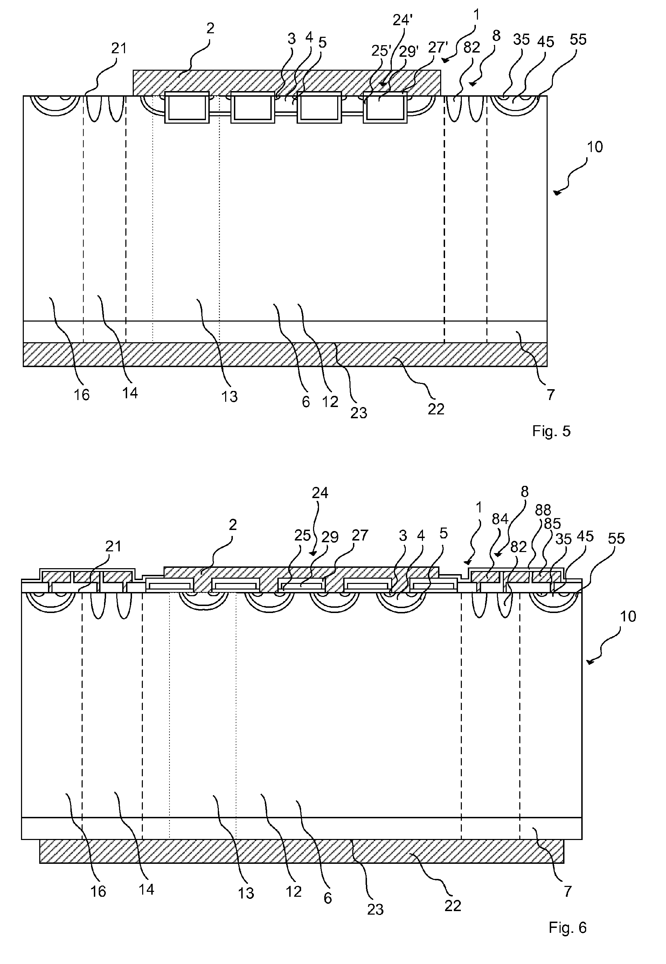

Alternatively to an inventive device with a planar gate electrode 24, an inventive device may comprise a gate electrode formed as trench gate electrode 24' as shown in FIG 5. The trench gate electrode 24' comprises an electrically conductive gate layer 29', which is arranged in the same plane as the first base layer 4 and adjacent to the first emitter layer 3, separated from each other by a first insulating layer 25', which also separates and thus insulates the electrically conductive layer 29' from the drift layer 6. A second insulating layer 27' is arranged on top of the electrically conductive layer 29', thus insulating the electrically conductive layer 29' from the emitter electrode 2 (FIG 5).

The inventive bipolar punch-through semiconductor devices can also be a reverse conducting IGBT with alternating p doped collector layer 7 and n+ doped additional layers in a plane parallel to the collector side.

In the termination area 14 at least one termination layer 8 is arranged, at which the electric field during operation of the insulated gate bipolar transistor 1 in blocking mode is reduced so that it decreases towards the edge of the wafer.

In the channel stopper area 16 a p doped second base layer 45 and an n doped second enhancement layer 55, which separates the second base layer 45 from the drift layer 6, are arranged. Due to the second enhancement layer 55, it is ensured that the electric field does not propagate to the edge of the wafer, i.e. the electric field is blocked.

Exemplarily, the first base layer 4 has the same maximum doping concentration as the second base layer 45, and the first enhancement layer 5 has the same maximum doping concentration as the second enhancement layer 55. Exemplarily, the second base layer 4 and the second enhancement layer 55 have the same doping profile and the same thickness as the plurality of first base layers 4 and first enhancement layers 5 in a direction perpendicular to the emitter side 21.

The doping profile is the doping concentration of a layer versus depth. The doping profile shall be measured in a direction perpendicular to the emitter side and in a region, in which the layer has its greatest depth, exemplarily in a central part of the layer. The same doping profile (measured along an axis perpendicular to the emitter side) means that the layers have for all depths (up to the maximum depth to which the appropriate layer extends from the emitter side) the same doping concentration (for the first base and enhancement layer compared to the second base and enhancement layer) for a given depth.

The first and second enhancement layers 5, 55 have a higher doping concentration than the drift layer 6. Exemplarily, the doping concentration increases steadily towards the emitter side 21 up to a maximum doping concentration between 5*10¹⁵ and 1*10¹⁷ cm⁻³.

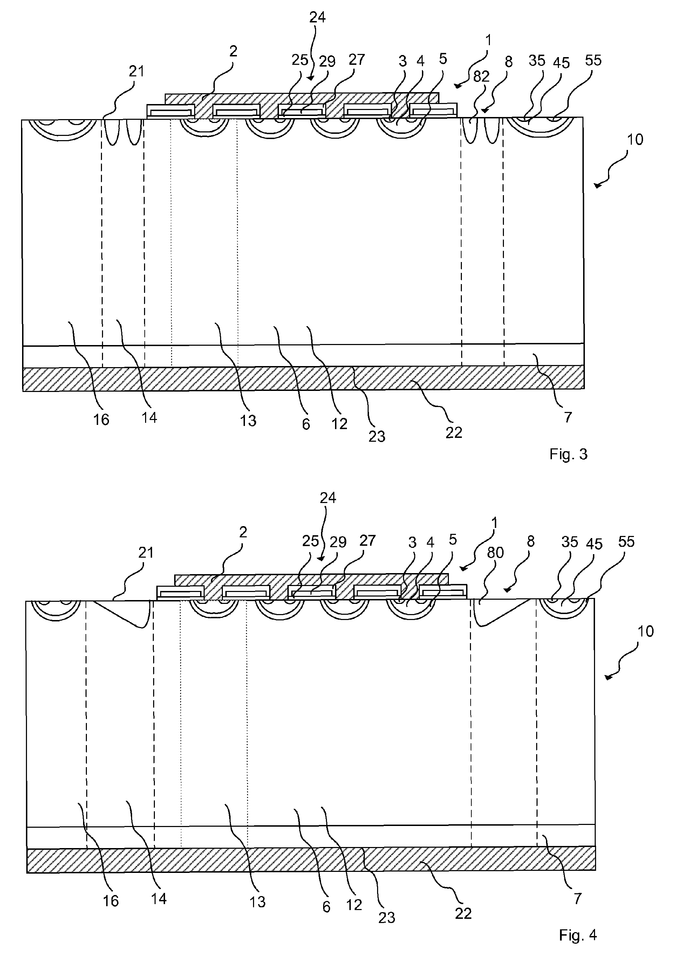

The second base layer 45 may have a maximum extension in a plane parallel to the emitter side 21 and in a direction from the central part towards to the edge of the wafer, which is different than the maximum extension of one or all of the first base layers 4, exemplarily larger as shown in Fig. 3 or smaller. Thus, the second enhancement layer 55 also has a maximum extension in a plane parallel to the emitter side 21 and in a direction from the central part towards to the edge of the wafer, which is larger than the maximum extension of the plurality of first enhancement layers 5.

In another exemplary embodiment, the inventive device has in the channel stopper area 16 an n doped second emitter layer 35, which is surrounded by the second base layer 45 (Fig. 1). In this case, the design of the layers on the emitter side is the same as in the active cell area, i.e. the doping profile of the first emitter layer 3, the first base layer 4 and the first enhancement layer 5 is the same as of the second emitter layer 35, the second base layer 45 and the second enhancement layer 55. Again, doping profile shall be measured perpendicular to the emitter side 21, at such a place, at which the layers have a maximum thickness measured from the emitter side 21 (or in a central part of the layer). The emitter layers 3, 35 have higher doping concentration than the drift layer 6.

Alternatively, there may be no highly doped n layer in form of a second emitter layer be arranged in the second base layer (Fig. 2).

In another embodiment, each of the at least one termination layer 8 surrounds the active cell area 12. Such a termination layer(s) may be formed as at least one p doped layer, which is arranged on the emitter side 21 in the wafer and extends to the surface of the wafer. The at least one p doped layer may be formed as a spirally wound layer, i.e. a continuous layer winding several times around the active cell area 12.

Alternatively, as shown in Fig. 1, the termination layer 8 may be formed as one or more p doped guard rings 82, each of which formed as closed rings, which completely surround the active cell area 12 in a plane parallel to the emitter side 21. Between the guard rings 82, the drift layer 6 extends to the surface of the wafer 10.

The termination layer 8 may also be a p doped VLD layer 80, in which the integral of the doping concentration in a plane perpendicular to the emitter side decreases with increasing distance from the active cell area 14 (Fig. 4). A VLD layer 80 is formed asymmetrically, i.e. from the point of greatest depth of the VLD layer 80 the layer has a smaller extension towards the active cell area than towards the edge of the wafer. Such a VLD layer 80 exemplarily is a multiple-diffused layer, in which ions have been diffused with higher doping concentration and into greater depth from the emitter side 21 in an area closer to the active cell area 12 than in an area farer away from the active cell area 12, i.e. closer to the edge of the wafer.

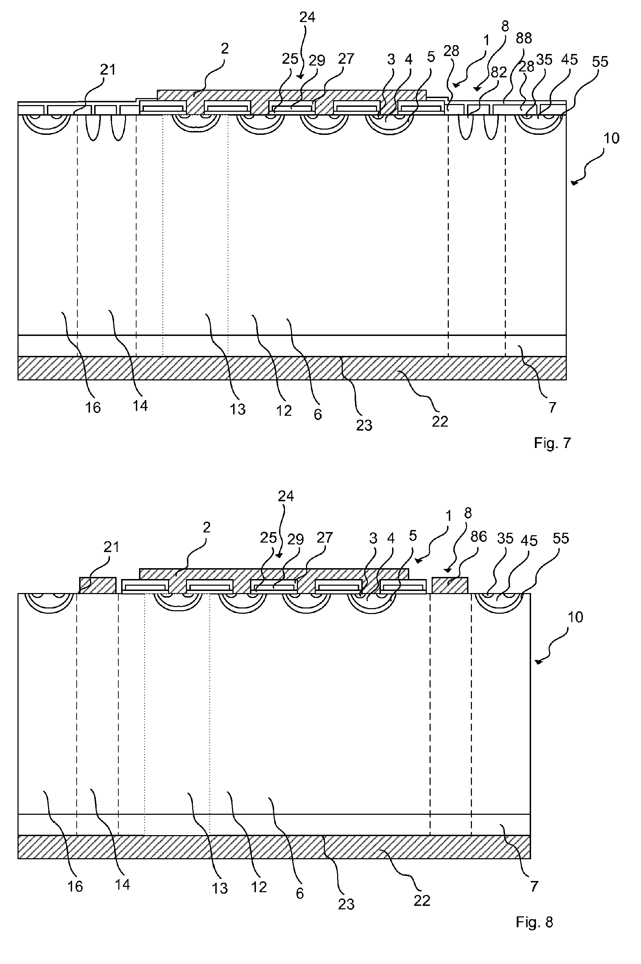

Such termination layer(s) 8 may be electrically connected to individual first electrically conductive plates 84. That means, that the electrically conductive plates 84 are separate, i.e. single plates. These plates 84 (as shown in Fig. 6) or the at least one termination layer (e.g. for a device without first electrically conductive plates 8; shown in Fig. 7) may be connected to the emitter electrode 2 by a semiconducting layer 88. Such a semiconducting layer 88 has a resistivity lower than of the plurality of first insulating layers 25 and higher than of the emitter electrode 2. Exemplarily, the resistivity ranges between 10 and 100 Ω cm. The semiconducting layer 88 is exemplarily an amorphous silicon layer or a SIPOS layer, i.e. a semi-insulating polycrystalline silicon layer used for passivation.

Such a connection to the emitter electrode 2 is also possible via an additional p doped layer (e.g. in the form of a guard ring 82), which may be arranged in the termination area 14 as the closest p doped layer towards the active cell area 12.

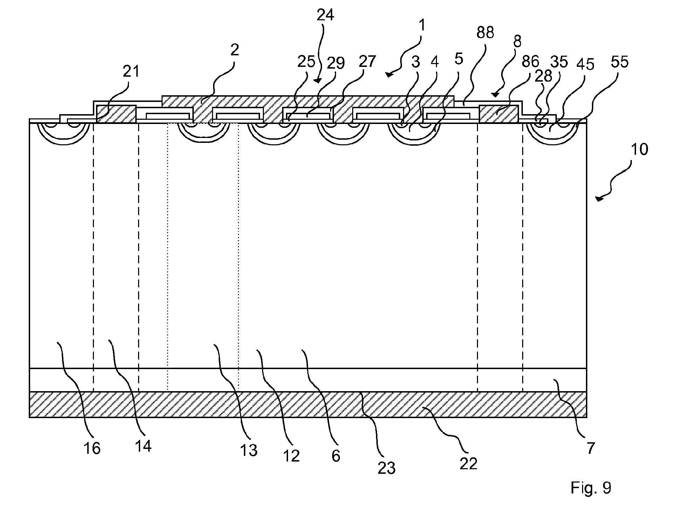

The termination layer 8 may also be formed as at least one electrically conductive field plate 86, which is arranged in the termination area 14 on top of the wafer 10 at the emitter side 21 (Fig. 8). As disclosed before, the electrically conductive field plate(s) 86 may be connected to the emitter electrode 2 by a semiconducting layer 88 (Fig. 9).

Such a semiconducting layer 88 may connect all termination layers in form of guard rings 82 or electrically conductive plates 84 or field plates 86 to each other.

In a further embodiment, the at least one of the second base layer 45, the second enhancement layer 55 and/or the at least one termination layer 8 are floating, i.e. not in direct contact to the emitter electrode 2 or any other electrode.

The second base layer 45 may be electrically connected to a further electrically conductive plate 85, which is exemplarily arranged on top of the wafer on the emitter side 21.

The second base layer 45 or the further electrically conductive plate 85 may also be electrically connected to the semiconducting layer 88.

Such inventive semiconductor devices may be manufactured as follows. An (n-) doped wafer 10, exemplarily of constant low doping concentration, is provided, which has an emitter side 21 and a collector side 23 opposite to the emitter side 21. Between the emitter side 21 and collector side 23 an active cell area 12, which extends from the emitter to the collector side 21, 23 in a central part of the wafer is arranged. A termination area 14 surrounds the active cell area 12 and a channel stopper area 16 surrounds the termination area 14 and is arranged at the edge of the wafer. The edge of the wafer is arranged on the lateral sides of the wafer between the emitter and collector side 21, 23.

The wafer 10 may already in the beginning comprise a uniformly and constantly low doped drift layer 6 on the emitter side 21 and a buffer layer 65, i.e. a highly doped n type layer (i.e. higher doped than the drift layer) on the collector side 23 of the wafer. The highly doped layer may be thicker than the buffer layer 65 in the finalized device in order to be able to work with a thicker, less fragile wafer 10, wherein material is removed from the collector side 23 before creating the collector layer 7. Of course, the wafer 10 may also be only made of constantly low doped material with a greater thickness than in the finalized device.

At least one termination layer 8, at which the electric field during operation of the insulated gate bipolar transistor (1) in blocking mode is reduced, is created in the termination area 14. The at least one termination layer 8 may be guard ring(s) 82, a spirally wound ring, a VLD layer 80 or electrically conductive field plate 86. Any of these layers can be made by applying a mask, e.g. an oxide mask on the emitter side 21 with openings in the termination area 14, so that ions, e.g. boron, can be applied limited to areas in the termination area 14, and diffused into the wafer 10.

Afterwards a plurality of first insulating layers 25 are selectively created, leaving contact openings for a contact of the first emitter layers 3 and the first base layers 4 to the emitter electrode 2. Additionally, the gate layers 29, 29' may also be applied at this stage or in a later step.

The plurality of gate layers 29, 29' may be created before applying the first ions. In this case, the plurality of gate layers 29, 29' is used as a part of the first and second mask. Or, the plurality of gate layers 29, 29' is created after the applying the first, second and/or third ions.

Then, an n type first dopant, e.g. phosphorous, is applied selectively on the emitter side 21 using the first insulating layers 25, 25' and a first protection layer, which covers the termination area 14, as a first mask, so that the first ions are applied in the active cell area (12) for the creation of a first enhancement layer 5 and the first ions are applied in the channel stopper area 16 for the creation of a second enhancement layer 55. No ions are applied in the termination area due to the protection layer, which may be made of the same material and simultaneously with the first insulating layer 25, 25'. Afterwards, the first ions are diffused into the wafer 10 up to a first depth 51 from the emitter side 21.

Then a p type second dopant, e.g. boron, is applied through the first mask on the emitter side 21, so that the second ions are applied in the active cell area 12 for the creation of the plurality of first base layers 4 and the second ions are applied in the channel stopper area 16 for the creation of a second base layer 45. Then the second ions are diffused into the wafer 10 up to a second depth 41 from the emitter side 21, which second depth 41 is lower than the first depth 51. That means that the first and second base layer 4, 45 are surrounded by the first and second enhancement layers 5, 55 and thereby, separated from the drift layer 6.

Another p dopant may be applied and diffused to a lower depth than the second ions in order to create a p doped contact layer, which has higher maximum doping concentration than the first base layer. The p contact layer has about the same lateral extension (i.e. in a plane parallel to the emitter side 21) as the first emitter layer 3.

Afterwards, an n type third dopant, e.g. Arsenic, is selectively applied through a second mask on the emitter side 21, which second mask at least comprises the first insulating layers 25 and the first protection layer (i.e. the first mask), so that the third ions are applied in the active cell area 12 for the creation of a plurality of first emitter layers 3. Then the third ions are diffused into the wafer 10 up to a third depth 31 from the emitter side 21, which third depth 31 is lower than the second depth 41 (and if a p contact layer is created also lower than the depth of the p contact layer).

The second mask may be the same mask as the first mask so that the third ions are applied in the active cell area 12 for the creation of a plurality of first emitter layers 3 and in the channel stopper area 16 for the creation of a second emitter layer 35. Alternatively, the second mask may additionally to the layers of the first mask comprise a second protection layer, which covers the channel stopper area 16 on the emitter side 21 before applying the third ions. In this case, only the first emitter layers 3 are created in the active cell area 12 and no highly doped n-type layer is created in the termination and channel stopper area.

The ions may exemplarily be applied by implantation or deposition for the creation of the various layers.

Afterwards a plurality of second insulating layers 27, 27', which cover the plurality of gate layers 29, 29', may be created, if they do not have been created before.

Then material is removed from the plurality of first emitter layers 3 (and any layer above the first emitter layer) so that a plurality of contact openings, which extend to the plurality of first base layers 3 (or p contact layer, which is again in contact with the first base layer; i.e. a contact to a p doped layer is created), is created, wherein the plurality of contact openings is laterally surrounded, in a plane parallel to the emitter side 21, by the plurality of first emitter layers 3. Exemplarily, another contact opening may be created for a contact to the second base layer or p contact layer (and, if present also to the second emitter layer 35).

Then, an emitter electrode 2 is created on the emitter side 21, wherein the emitter electrode 2 contacts the plurality of first emitter layers 3 and first base layers 4 at the plurality of contact openings and wherein the plurality of second insulating layers 27 insulates the plurality of gate electrodes 24, 24' from the emitter electrode 2. Exemplarily, an electrically conductive plate 84 is created on the channel stopper area 16, which contacts the second base layer 45 (or p doped contact layer in the channel stopper area 16), which plate is separated from the emitter electrode 2.

A semiconducting layer 88 may now be created, which contacts the termination layer 8 and exemplarily the second base layer 45 (and second emitter layer 35) or the electrically conductive plate 84. The semiconducting layer 88 is also in contact to the emitter electrode 2, exemplarily by a p doped layer (e.g. in the form of a guard ring 82), which may be arranged in the termination area 14 as the closest p doped layer towards the active cell area 12. Afterwards, a third insulating layer may be created on the semiconducting layer 88.

A buffer layer 65 may optionally be manufactured on the collector side 23 now.

If a thicker wafer than in the finalized device has been used, the wafer thickness may now be reduced on the collector side 23, e.g. by grinding.

Now, on the collector side 23, a p collector layer 7 is created, and afterwards a collector electrode 22 is created on the collector side 23.

In case of a reverse conducting IGBTs the doped collector layer 7 alternating with an n+ doped additional layer is created in a plane parallel to the collector side 23 by using masking techniques well-known to experts.

Alternatively, the emitter electrode 2 may be created together with the collector electrode 23.

In another embodiment, the conductivity types are switched, i.e. all layers of the first conductivity type are p type (e.g. the drift layer 6, the emitter layers 3, 35) and all layers of the second conductivity type are n type (e.g. base layers 4, 45, the collector layer 7).

These examples shall not limit the scope of the invention. The above mentioned designs and arrangements are just examples for any kinds of possible designs and arrangements.

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### Reference List

- 1: IGBT
- 10: wafer
- 12: active cell area
- 13: cell
- 14: termination area
- 16: channel stopper area
- 2: emitter electrode
- 21: emitter side
- 22: collector electrode
- 23: collector side
- 24, 24': gate electrode
- 25, 25': first insulating layer
- 27, 27': second insulating layer
- 29, 29': gate layer
- 3: first emitter layer
- 31: third depth
- 35: second emitter layer
- 4: first base layer
- 41: second depth
- 45: second base layer
- 5: first enhancement layer
- 51: first depth
- 55: second enhancement layer
- 6: drift layer
- 65: buffer layer
- 7: collector layer
- 8: termination layer
- 80: VLD layer
- 82: guard ring
- 84: electrically conductive plate
- 85: further electrically conductive plate
- 86: field plate
- 88: semiconducting layer

## Claims

1. Insulated gate bipolar transistor (1) having on a wafer (10), which has an emitter electrode (2) on an emitter side (21) and a collector electrode (22) on a collector side (23) opposite to the emitter side (21), an active cell area (12), which extends from the emitter side (21) to the collector side (23) in a central part of the wafer, a termination area (14), which surrounds the active cell area (12), and a channel stopper area (16), which is arranged around the termination area (14) at the edge of the wafer,
wherein in the active cell area (12) a plurality of cells (13) are arranged, each comprising layers in the following order between the emitter side (21) and collector side (23): a first emitter layer (3) of a first conductivity type, a first base layer (4) of a second conductivity type, which is different from the first conductivity type, a first enhancement layer (5) of the first conductivity type, a drift layer (6) of the first conductivity type, a collector layer (7) of the second conductivity type, wherein the first enhancement layer (5) separates the first base layer (4) from the drift layer (6),
wherein the emitter electrode (2) is electrically connected to the plurality of first emitter layers (3) and first base layers (4), and
a plurality of gate electrodes (24, 24') are arranged on the emitter side (21), each of which comprises an electrically conductive gate layer (29, 29') and a first and second insulating layer (25, 25', 27, 27'), wherein the gate layer (29, 29') is separated from any of the layers in the wafer (10) by the first insulating layer (25, 25') and from the emitter electrode (2) by the second insulating layer (27, 27'), wherein the collector electrode (22) is electrically connected to the collector layer (7),
wherein in the termination area (14) at least one termination layer (8) is arranged, at which the electric field during operation of the insulated gate bipolar transistor (1) in blocking mode is reduced,
**characterized in that** in the channel stopper area (16) a second base layer (45) of the second conductivity type and a second enhancement layer (55) of the first conductivity type, which separates the second base layer (45) from the drift layer (6), is arranged.

2. Insulated gate bipolar transistor (1) according to claim 1, **characterized in that** the second base layer (45) and the second enhancement layer (55) have the same doping profile and the same thickness as the plurality of first base layers (4) and first enhancement layers (5) in a direction perpendicular to the emitter side (21).

3. Insulated gate bipolar transistor according to any of the claims 1 or 2, **characterized in that** the second base layer (45) and the second enhancement layer (55) have a maximum extension in a plane parallel to the emitter side (21) and in a direction from the central part of the wafer towards to the edge of the wafer, which is larger than the maximum extension of the plurality of first base layers (4) and first enhancement layers (5) in the same plane.

4. Insulated gate bipolar transistor (1) according to any of the claims 1 to 3, **characterized in that** in the channel stopper area (16) a second emitter layer (35) of the first conductivity type is arranged, which is surrounded by the second base layer (45).

5. Insulated gate bipolar transistor (1) according to any of the claims 1 to 4, **characterized in that** each of the at least one termination layer (8) surrounds the active cell area (12) and **in that** the at least one termination layer (8) is one of a spirally wound layer of the second conductivity type,
at least one guard ring (82) of the second conductivity type, and
a VLD layer (80) of the second conductivity type, in which the integral of the doping concentration in a direction perpendicular to the emitter side (21) decreases with increasing distance from the active cell area (12) towards the channel stopper area (16).

6. Insulated gate bipolar transistor (1) according to any of the claims 5, **characterized in that** each of the at least one termination layer (8) is electrically connected to individual first electrically conductive plates (84).

7. Insulated gate bipolar transistor (1) according to any of the claims 1 to 3, **characterized in that** the termination layer (8) is at least one electrically conductive field plate (86), which is arranged in the termination area (14) on top of the wafer (10) at the emitter side (21).

8. Insulated gate bipolar transistor (1) according to any of the claims 5 to 7, **characterized in that** at least one of the second enhancement layer (55) and the at least one termination layer (8) is floating.

9. Insulated gate bipolar transistor (1) according to any of the claims 1 to 8, **characterized in that** the second base layer (45) is electrically connected to a second electrically conductive plate (85).

10. Insulated gate bipolar transistor (1) according to any of the claims 1 to 7, **characterized in that** each of the at least one termination layer (8) is electrically connected to a semiconducting layer (88), which has a resistivity lower than of the plurality of first insulating layers (25) and higher than of the emitter electrode (2), wherein the semiconducting layer (88) is electrically connected to the emitter electrode (2).

11. Insulated gate bipolar transistor (1) according to claim 10, **characterized in that** the second base layer (45) is electrically connected to the semiconducting layer (88).

12. Insulated gate bipolar transistor (1) according to claim 10, **characterized in that** the second base layer (45) is electrically connected to a second electrically conductive plate (85), and **in that** the second electrically conductive plate (85) is electrically connected to the semiconducting layer (88).

13. Insulated gate bipolar transistor (1) according to any of the claims 10 to 12, **characterized in that** the semiconducting layer (88) is an amorphous silicon layer or a SIPOS layer.

14. Insulated gate bipolar transistor (1) according to any of the claims 1 to 13, **characterized in that** the drift layer is constantly low doped and **in that** the first and second enhancement layers (5, 55) have a higher doping concentration than of the drift layer, in particular a doping concentration, which increases steadily towards the emitter side (21).

15. Method for manufacturing an insulated gate bipolar transistor (1) according to any of the claims 1 to 14, **characterized in that** the following manufacturing steps are performed:
- providing a wafer (10) of a first conductivity type, which has an emitter side (21) and a collector side (23) opposite to the emitter side (21), and which has between the emitter side (21) and collector side (23) an active cell area (12), which extends from the emitter to the collector side (21, 23) in a central part of the wafer, a termination area (14) surrounding the active cell area (12) and a channel stopper area (16), which is arranged around the termination area (14) at the edge of the wafer on the emitter side (21),
- then creating on the emitter side (21) at least one termination layer (8) in the termination area (14), at which the electric field during operation of the insulated gate bipolar transistor (1) in blocking mode is reduced,
- then selectively creating on the emitter side (21) a plurality of first insulating layers (25),
- then selectively applying on the emitter side (21) a first dopant of a first conductivity type using the first insulating layers (25, 25') as a first mask, which first mask further comprises a first protection layer, which covers the termination area (14), so that the first dopant is applied in the active cell area (12) for the creation of a first enhancement layer (5) and the first dopant is applied in the channel stopper area (16) for the creation of a second enhancement layer (55), then diffusing the first ions into the wafer (10) up to a first depth (51) from the emitter side (21),
- then selectively applying on the emitter side (21) a second dopant of a second conductivity type, which is different from the first conductivity type, through the first mask, so that the second dopant is applied in the active cell area (12) for the creation of the plurality of first base layers (4) and the second dopant is applied in the channel stopper area (16) for the creation of a second base layer (45), then diffusing the second ions into the wafer (10) up to a second depth (41) from the emitter side (21), which second depth (41) is lower than the first depth (51),
- then selectively applying on the emitter side (21) a third dopant of the first conductivity type through a second mask, which second mask comprises at least the first insulating layers (25) and the first protection layer (xx), so that the third dopant is applied in the active cell area (12) for the creation of a plurality of first emitter layers (3), then diffusing the third dopant into the wafer (10) up to a third depth (31) from the emitter side (21), which third depth (31) is lower than the second depth (41),
- then removing material from the plurality of first emitter layers (3) so that a plurality of contact openings, which extend to the plurality of first base layers (3), is created, wherein the plurality of contact openings are laterally surrounded by the plurality of first emitter layers (3),
- creating a plurality of gate layers (29, 29'), wherein the plurality of gate layers (29, 29') is separated from any of the layers in the wafer (2) by the plurality of first insulating layers (25), and afterwards creating a plurality of second insulating layers (27), which cover the plurality of gate layers (29, 29'), wherein a plurality of gate electrodes (24, 24') comprises the gate layers (29, 29') and the first and second insulating layers (25, 25', 27, 27'),
- creating a collector layer (7) on the collector side (23), and afterwards creating a collector electrode (22) on the collector side (23),
- creating an emitter electrode (2) on the emitter side (21), wherein the emitter electrode (2) contacts the plurality of first emitter layers (3) and the first base layers (3) at the plurality of contact openings and wherein the plurality of second insulating layers (27) insulates the plurality of gate layers (29, 29') from the emitter electrode (2).

16. Method for manufacturing an insulated gate bipolar transistor (1) according to claim 15, **characterized in that**
applying a second protection layer, which covers the channel stopper area (16), before applying the third dopant, which second protection layer is part of the second mask, or **in that**
the second mask is the same mask as the first mask so that the third dopant is applied in the channel stopper area (16) for the creation of a second emitter layer (35).

17. Method for manufacturing an insulated gate bipolar transistor (1) according to any of the claims 15 or 16, **characterized in that**
creating the plurality of gate layer (29, 29') before applying the first dopant and using the plurality of gate layer (29, 29') as a part of the first mask.
